# EUROPÄISCHE PATENTSCHRIFT

(11) **EP 0 486 489 B1**
(45) Veröffentlichungstag und Bekanntmachung des Hinweises auf die Patenterteilung: **02.11.1994**
(21) Anmeldenummer: 89909536.8
(22) Anmeldetag: 10.08.1989
(51) Int. Cl.: C23C 30/00, C22C 19/00

(54) **HOCHTEMPERATURFESTE KORROSIONSSCHUTZBESCHICHTUNG, INSBESONDERE FÜR GASTURBINENBAUTEILE**
HIGH-TEMPERATURE-RESISTANT, CORROSION-RESISTANT COATING, IN PARTICULAR FOR COMPONENTS OF GAS TURBINES
REVETEMENT ANTICORROSION RESISTANT AUX TEMPERATURES ELEVEES, NOTAMMENT POUR ELEMENTS DE TURBINES A GAZ

(43) Veröffentlichungstag der Anmeldung: 27.05.1992
(73) Patentinhaber: SIEMENS AKTIENGESELLSCHAFT, 80333 München (DE)
(72) Erfinder: CZECH, Norbert, D-4330 Mülheim (DE); SCHMITZ, Friedhelm, D-4220 Dinslaken (DE)
(86) Internationale Anmeldenummer: DE8900528
(87) Internationale Veröffentlichungsnummer: WO9102108

(56) Entgegenhaltungen:
- EP-A- 0 025 263
- DE-A- 1 758 010
- FR-A- 2 511 042
- GB-A- 2 095 700
- GB-A- 2 103 656
- US-A- 4 034 142
- US-A- 4 346 137

## Beschreibung

Die vorliegende Erfindung betrifft eine Schutzbeschichtung, insbesondere für Gasturbinenbauteile und andere Bauteile aus Nickel-Basis- oder Kobalt-Basis-Legierungen.

Schutzbeschichtungen aus Legierungen, die im wesentlichen Nickel, Chrom, Kobalt, Aluminium und ein reaktives Element der seltenen Erden enthalten, wurden in zahlreichen Zusammensetzungen entwickelt und getestet. Eine solche Beschichtung ist beispielsweise aus der US-PS 4,005,989 bekannt. Aus der US-PS 4,034,142 ist auch bekannt, daß ein zusätzlicher Anteil an Silizium die Eigenschaften solcher Schutzbeschichtungen weiter verbessern kann. Die relativ weiten Bereiche der einzelnen Elemente in diesen Dokumenten zeigen zwar qualitativ einen Weg zur Schaffung von hochtemperatur-korrosionsfesten Schutzschichten, jedoch sind die angegebenen Zusammensetzungen quantitativ nicht für alle Aufgabenstellungen genügend spezifiziert.

Aus der DE-PS 23 55 674 sind weitere Zusammensetzungen von Schutzschichten bekannt, die jedoch nicht für Anwendungen geeignet sind, je sie bei stationären Gasturbinen mit hoher Eintrittstemperatur auftreten können.

Aufgabe der vorliegenden Erfindung ist daher die Schaffung einer Schutzbeschichtung, die eine hohe Korrosionsfestigkeit sowohl bei mittleren Temperaturen wie auch bei hohen Temperaturen aufweist. Die Korrosionseigenschaften sollen im Temperaturbereich von 600 bis etwa 1150° C so verbessert werden, daß insbesondere solche Schutzbeschichtungen bei stationären Gasturbinenanlagen, die im Teillast- oder Vollastbetrieb arbeiten, eingesetzt werden können.

Die Lösung dieser Aufgabe wird durch eine bei mittleren bis hohen Temperaturen korrosionsfeste Schutzbeschichtung erreicht, die folgende Elemente (in Gewichtsprozent) enthält:
25 - 40 % Nickel,
28 - 32 % Chrom,
7 - 9 % Aluminium,
1 - 2 % Silizium,
0,3 - 1 % wenigstens eines reaktiven Elementes der seltenen Erden; mindestens 5 % Kobalt; sowie wahlweise 0 - 15 % wenigstens eines der Elemente aus der Gruppe bestehend aus Rhenium, Platin, Palladium, Zirkon, Mangan, Wolfram, Titan, Molybdän, Niob, Eisen, Hafnium, Tantal;
Rest Kobalt und Verunreinigungen.

Den einzelnen Bestandteilen der Schutzbeschichtung können dabei folgende Eigenschaften bzw. Bedeutungen zugeordnet werden:
Kobalt bewirkt als Bestandteil gute Korrosionseigenschaften bei hohen Temperaturen.

Nickel verbessert die Duktilität der Beschichtung und verringert die Interdiffusion gegenüber Nickel-Basis-Grundwerkstoffen. Bevorzugter Bereich für Nickel ist 25 bis 35 %, vorzugsweise etwa 30 %.

Chrom verbessert die Korrosionseigenschaften bei mittleren Temperaturen bis etwa 900° C und unterstützt die Bildung einer Aluminiumoxid-Deckschicht. Bevorzugter Bereich für Chrom ist 29 bis 31 %, insbesondere etwa 30 %.

Aluminium verbessert die Korrosionseigenschaften bei hohen Temperaturen bis etwa 1150° C. Bevorzugte Anteile von Aluminium sind 7,5 bis 8,5 %, insbesondere etwa 8 %.

Silizium unterstützt die Wirkung von Chrom und Aluminium und begünstigt die Haftung der schützenden Oxidschicht. Ein günstiger Bereich für den Siliziumanteil ist 1 bis 2 %, vorzugsweise etwa 1,5 %. Durch den Zusatz von Silizium können der Aluminiumanteil und/oder der Chromanteil von den für gute Korrosionseigenschaften eigentlich gewünschten hohen Gehalten auf für die Duktilität günstigere Werte gesenkt werden, ohne daß sich dabei die Korrosionseigenschaften verschlechtern.

Die Wirkung eines reaktiven Elementes, insbesondere von Yttrium, ist an sich bekannt. Bevorzugter Bereich hier ist 0,3 bis 1 %, insbesondere etwa 0,6 %.

In den angegebenen Vorzugsbereichen haben sich bei Versuchen besonders gute Korrosionseigenschaften für Anwendungen in Gasturbinen mit einer Eintrittstemperatur oberhalb von 1200° C ergeben.

Aus der Literatur sind verschiedene Elemente bekannt, welche bei eine Beimischung im Bereich unter 15 %, insbesondere bei einem Anteil von wenigen Prozent, die Eigenschaften einer Schutzbeschichtung nicht verschlechtern, sondern in mancher Hinsicht sogar verbessern. Die vorliegende Erfindung soll auch Legierungen mit solchen Beimischungen erfassen.

Es hat sich außerdem gezeigt, daß ein für Schutzbeschichtungen kaum in Betracht gezogenes Element, nämlich Rhenium, die Korrosionseigenschaften deutlich verbessern kann, wenn es in einem Anteil von 1 bis 15 %, vorzugsweise 4 bis 10 %, insb. etwa 7 %, beigemischt wird. Obwohl Rhenium nicht so teuer wie die meisten Edelmetalle ist, kann es als Bestandteil einer Schutzbeschichtung ähnlich gute Eigenschaften bewirken wie beispielsweise Platin und auch schon in kleinen Anteilen wirksam sein.

Die erfindungsgemäßen Beschichtungen können in an sich bekannter Weise durch Plasmaspritzen oder Aufdampfen (PVD) aufgebracht werden und sind besonders geeignet für Gasturbinenschaufeln aus einer Superlegierung auf Nickelbasis oder Kobaltbasis. Auch andere Gasturbinenbauteile, insbesondere bei Gasturbinen mit hoher Eintrittstemperatur von z. B. über 1200° C, können mit solchen Schutzbeschichtungen versehen werden.
Die erfindungsgemäße, spezielle Zusammensetzung der Beschichtung hat sich in Versuchen als besonders geeignete Auswahl für stationäre Gasturbinen mit hoher Eintrittstemperatur erwiesen.

## Patentansprüche

1. Bei mittleren und hohen Temperaturen, bis z. B. 1150° C, korrosionsfeste Schutzbeschichtung, insbesondere für Gasturbinenteile aus Nickel-Basis- oder Kobalt-Basis-Legierungen, enthaltend folgende Elemente (in Gewichtsprozent):
25 - 40 % Nickel,
28 - 32 % Chrom,
7 - 9 % Aluminium,
1 - 2 % Silizium,
0,3 - 1 % wenigstens eines reaktiven Elementes der seltenen Erden;
mindestens 5 % Kobalt;
sowie wahlweise 0 bis 15 % wenigstens eines der Elemente aus der Gruppe bestehend aus Rhenium, Platin, Palladium, Zirkon, Mangan, Wolfram, Titan, Molybdän, Niob, Eisen, Hafnium, Tantal;
Rest Kobalt und Verunreinigungen.

2. Schutzbeschichtung nach Anspruch 1, wobei das reaktive Element Yttrium ist.

3. Schutzbeschichtung nach Anspruch 2, wobei die Anteile an
| | | |
|---|---|---|
| Nickel | 25 - 35 % | |
| Chrom | 29 - 31 % | |
| Aluminium | 7,5 - 8,5 % | |
| Silizium | 1 - 2 % | |
| Yttrium | 0,3 - 1 % | betragen. |

4. Schutzbeschichtung nach Anspruch 3, wobei die Anteile an
| | | |
|---|---|---|
| Nickel | etwa 30 % | |
| Chrom | etwa 30 % | |
| Aluminium | etwa 8 % | |
| Yttrium | etwa 0,6 % | |
| Silizium | etwa 1,5 % | betragen. |

5. Schutzbeschichtung nach Anspruch 1, 2, 3 oder 4 mit einem Anteil von 1 - 15 % Rhenium.

6. Schutzbeschichtung nach Anspruch 5 mit einem Anteil von 4 bis 10 % Rhenium.

7. Schutzbeschichtung nach Anspruch 6 mit einem Anteil von etwa 7 % Rhenium.

8. Schutzbeschichtung nach einem der vorhergehenden Ansprüche, **dadurch gekennzeichnet**, daß die Beschichtung durch Plasmaspritzen oder Aufdampfen hergestellt ist.

## Claims

1. A protective coating resistant to corrosion at intermediate and high temperatures, e.g. up to 1150°C, particularly for gas turbine components made of nickel base or cobalt base alloys, containing the following elements (in percent by weight):
25 - 40% nickel,
28 - 32% chromium,
7 - 9% aluminium,
1 - 2% silicon,
0.3 - 1% of at least one reactive rare earth element, at least 5% cobalt, and optionally
0 - 15% of at least one of the elements of the group consisting of rhenium, platinum, palladium, zirconium, manganese, tungsten, titanium, molybdenum, niobium, iron, hafnium and tantalum;
the balance being cobalt and impurities.

2. A protective coating according to claim 1, wherein the reactive element is yttrium.

3. A protective coating according to claim 2, wherein the contents are as follows:
| | |
|---|---|
| nickel | 25 - 35 % |
| chromium | 29 - 31 % |
| aluminium | 7.5 - 8.5% |
| silicon | 1 - 2 % |
| yttrium | 0.3 - 1 %. |

4. A protective coating according to claim 3, wherein the contents are as follows:
| | |
|---|---|
| nickel | about 30 % |
| chromium | about 30 % |
| aluminium | about 8 % |
| yttrium | about 0.6% |
| silicon | about 1.5%. |

5. A protective coating according to claim 1, 2, 3 or 4 with a rhenium content of 1 - 15%.

6. A protective coating according to claim 5 in which the rhenium content is 4 to 10%.

7. A protective coating according to claim 6 in which the rhenium content is about 7%.

8. A protective coating according to any preceding claim, characterised in that the coating is produced by plasma spraying or vapour deposition.

## Revendications

1. Revêtement protecteur résistant à la corrosion à des températures moyennes et hautes allant jusqu'à 1150°C par exemple, notamment pour des pièces de turbine à gaz en alliage à base de nickel ou à base de cobalt, contenant les éléments suivants (en pourcentages en poids) :
25 à 40 % de nickel,
28 à 32 % de chrome,
7 à 9 % d'aluminium,
1 à 2 % de silicium,
0,3 à 1 % d'au moins un élément réactif des terres rares;
au moins 5 % de cobalt;
ainsi qu'éventuellement de 0 à 15 % au moins d'un des éléments choisis dans le groupe constitué du rhénium, du platine, du palladium, du zirconium, du manganèse, du tungstène, du titane, du molybdène, du niobium, du fer, de l'hafnium, du tantale; le reste étant du cobalt et des impuretés.

2. Revêtement protecteur suivant la revendication 1, dans lequel l'élément réactif est l'yttrium.

3. Revêtement protecteur suivant la revendication 2, dans lequel les proportions sont
de 25 à 35 % de nickel;
de 29 à 31 % de chrome;
de 7,5 à 8,5 % d'aluminium
de 1 à 2 % de silicium;
de 0,3 à 1 % d'yttrium.

4. Revêtement protecteur suivant la revendication 3, dans lequel les proportions sont
d'environ 30 % de nickel,
d'environ 30 % de chrome,
d'environ 8 % d'aluminium,
d'environ 0,6 % d'yttrium,
d'environ 1,5 % de silicium.

5. Revêtement protecteur suivant la revendication 1, 2, 3 ou 4, ayant une proportion de 1 à 15 % de rhénium.

6. Revêtement protecteur suivant la revendication 5, ayant une proportion de 4 à 10 % de rhénium.

7. Revêtement protecteur suivant la revendication 6, ayant une proportion d'environ 7 % de rhénium.

8. Revêtement protecteur suivant l'une des revendications précédentes, caractérisé en ce que le revêtement est fabriqué par projection au plasma ou par dépôt en phase vapeur.
